# EUROPÄISCHE PATENTANMELDUNG

(11) **EP 2 149 437 A1**
(43) Veröffentlichungstag der Anmeldung: **03.02.2010**
(21) Anmeldenummer: 09161767.0
(22) Anmeldetag: 03.06.2009
(51) Int. Cl.: B26D 1/00, B26F 1/44, B32B 18/00, D06M 11/00, H01M 2/00

(54) **Verwendung von keramischen oder keramikhaltigen Schneid- oder Stanzwerkzeugen als Schneiden oder Stanzen für keramikhaltige Verbundstoffe**

(30) Priorität: 31.07.2008 DE 102008040896
(71) Anmelder: Evonik Degussa GmbH, 45128 Essen (DE)
(72) Erfinder: Rex, Friedemann, 45772 Marl (DE); Pascaly, Matthias, 48163 Münster (DE); Trocha, Martin, 45136 Essen (DE); Hying, Christian, 46414 Rhede (DE)

(57) **Zusammenfassung**

Die vorliegende Erfindung betrifft ein Verfahren zum Schneiden und/oder Stanzen von Material bei dem sich abrasive Partikel innerhalb und/oder auf der Oberfläche eines Trägers befinden. Die Erfindung betrifft insbesondere ein Verfahren zum Schneiden und/oder Stanzen von keramischen Separatoren, die zum Beispiel in Lithium-lonen-Batterien eingesetzt werden.

## Beschreibung

Die Erfindung betrifft ein Verfahren zum Schneiden und/oder Stanzen von abrasivem Material, also Material bei dem sich abrasive Partikel innerhalb und/oder auf der Oberfläche eines Trägers befinden. Die Erfindung betrifft insbesondere ein Verfahren zum Schneiden und/oder Stanzen von keramischen bzw. keramische oder oxidische Bestandteile enthaltenden Separatoren, die zum Beispiel in Lithium-lonen-Batterien eingesetzt werden.

Für den Einsatz in Lithium-lonen-Batterien werden unter anderem Separatoren verwendet, die z. B. aus einer mit keramischen Bestandteilen beschichteten oder keramische Bestandteile enthaltenden Trägersubstanz bestehen. Die keramischen Bestandteile dieser sogenannten keramischen Separatoren können aus Aluminiumoxid (Al₂O₃) und Siliziumoxid (SiO₂) sowie weiteren Metalloxiden wie bspw. BaTiO₃, ZrO₂ oder TiO₂ bestehen. Die Trägersubstanzen können dabei z. B. aus Polymeren, wie Polyolefinen, Polyestern, Polyimiden, bestehen. Die keramischen Bestandteile können sowohl in das Polymer eingebracht werden, wobei dann das Polymer als Matrix und das Oxid als Füller dient, als auch auf einen porösen Polymerträger in Form einer Imprägnierung, Bedruckung oder Tränkung aufgebracht werden.

Keramische oder halbkeramische (hybride) Separatoren oder als Separatoren einsetzbare keramische Membranen sind z. B. aus WO 99/15262 hinlänglich bekannt. Aus dieser Schrift kann auch die Herstellung von Separatoren oder Membranen, die als Separatoren geeignet sind, entnommen werden. Vorzugsweise werden als poröse Träger für die genannten Separatoren allerdings keine elektrisch leitfähigen Träger wie z. B. Metallgewebe eingesetzt, da es bei der Verwendung solcher Träger zu inneren Kurzschlüssen kommen kann, wenn die keramische Beschichtung des Trägers nicht vollständig ist. Die genannten Separatoren weisen deshalb bevorzugt Träger aus nicht elektrisch leitfähigen Materialien auf.

In neuester Zeit sind hybride Separatoren entwickelt worden, die Keramiken und Polymere aufweisen. In DE 102 08 277 wurden Separatoren basierend auf polymeren Substratmaterialien, wie z. B. Polymervliesen, hergestellt, die eine poröse, elektrisch isolierende, keramische Beschichtung aufweisen.

Solche keramischen Separatoren werden üblicherweise mit gewöhnlichen handelsüblichen Schneidutensilien wie Rundmessern, Scheren, Hebelscheren, etc. mit Klingen aus herkömmlichem oder auch gehärtetem Messerstahl in die gewünschte Form geschnitten. Hierbei ist nachteilig, dass beim Schneiden und/oder Stanzen zum Teil ein enormer Materialverlust durch Abrieb beobachtet wird. Des Weiteren wird die Klinge bei dieser Verwendung wohl aufgrund des Abriebs sehr schnell stumpf. Die Folge sind unter anderem auch unsaubere Schnittbilder.

Keramische Separatoren, die z. B. als Rollenware vorliegen, werden für ihre Verwendung in Lithium-lonen-Batterien auf die dafür notwendigen Dimensionen geschnitten. Das Schneiden und/oder Stanzen der Separatoren kann mit konventionellen Schneidwerkzeugen wie z. B. Schere, Messer, Stanze, etc. erfolgen. Dabei werden für die Herstellung dieser konventionellen Werkzeuge in der Regel Stahl, z. B. Edelstähle, Schwedenstahl oder pulvermetallurgischer Schnellstahl, verwendet. Das Schneiden und/oder Stanzen der keramischen Separatoren mit stahlbasierten Werkzeugen führt aber zu Metallabrieb an den Werkzeugen, der dann auf den Separatoren haften bleibt. Diese mit Metallabrieb kontaminierten keramischen Separatoren können nun zu unerwünschten Effekten bei deren Verwendung in Lithium-lonen-Batterien führen. So kann Metallabrieb auf dem Separator elektrische Kurzschlüsse in der Batterie zur Folge haben. Die Kurzschlüsse können dabei sowohl durch die elektrische Leitfähigkeit des Metallabriebs hervorgerufen werden aber auch durch Beschädigungen der Separatoren wenn auf Grund der Dimensionen der Abriebpartikel ein Durchdrücken oder Durchpressen dieser Partikel erfolgt.

Aufgabe der vorliegenden Erfindung war es nun, ein Verfahren zum Zuschneiden und/oder Stanzen eines abrasiven Materials zur Verfügung zu stellen, wobei nach dem Schneiden und/oder Stanzen eine saubere Schnittkante zurückbleibt, kein Abrieb entsteht, der zu Verunreinigungen des geschnittenen Materials führt, insbesondere kein metallischer Abrieb entsteht, der zu Kurzschlüssen bei Verwendung des geschnittenen Materials in Batterien führt, und wobei das verwendete Schneidwerkzeug eine hohe Standzeit und geringe Verstumpfung aufweist.

Gelöst wird diese Aufgabe in überraschender Weise durch ein Verfahren zum Schneiden und/oder Stanzen eines Materials, das einen Träger und abrasive Partikel umfasst, wobei sich die abrasiven Partikel innerhalb und/oder auf zumindest einem Teil der Oberfläche des Trägers befinden, **dadurch gekennzeichnet, dass** zum Schneiden und/oder Stanzen des Materials ein mit einem keramischen Werkstoff beschichtetes Schneidwerkzeug oder ein aus einem keramischen Werkstoff bestehendes Schneidwerkzeug oder ein sonstiges einen keramischen Werkstoff umfassendes Schneidwerkzeug verwendet wird.

Die Verwendung der beschriebenen Schneidwerkzeuge in dem erfindungsgemäßen Verfahren stellt eine wesentliche Verbesserung gegenüber herkömmlichen Schneideverfahren dar. Dies zeigt sich insbesondere bei Separatormaterialien mit keramischen Füllungen oder Beschichtungen wie SEPARION® der Firma EVONIK aber auch anderen flächigen, gegebenenfalls aufgewickelten keramischen Werkstoffen, die zurechtgeschnitten werden müssen. SEPARION® ist eine keramisch-polymere Verbundwerkstofffolie, wobei die keramischen Partikel bestehend aus Al₂O₃ sowie SiO₂ in und auf ein Polymervlies ein- und aufgebracht sind, zur Verwendung als Separator für Lithium-lonen-Batterien. Auch andere abrasive Materialien, wie z. B. Schleifpapier, lassen sich hervorragend mit den beschriebenen Schneid- oder Stanzwerkzeugen schneiden bzw. stanzen. Die Vorteile der erfindungsgemäßen Verwendung liegen in einem verbesserten, d. h. saubererem Schnittbild, reduziertem Abrieb, wesentlich höheren Standzeiten der verwendeten Klingen ohne Klingenabrieb bzw. Verstumpfung der Schneide, weniger Verunreinigungen sowohl der Schneidmaschine als auch des geschnittenen Werkstoffes und Vermeidung metallischen Abriebs, der zu Kurzschlüssen bei Verwendung des Werkstoffes in der Batterie führen kann.

Das nach dem erfindungsgemäßen Verfahren zu schneidende und/oder zu stanzende Material kann z. B. einen Träger umfassen, der aus Kunststoff, aus porösem Kunststoff, aus einem Vlies oder Gewebe aus solchen Kunststoffen, aus Papier oder Pappe besteht oder der zumindest eines dieser Materialien umfasst. Das zu schneidende und/oder zu stanzende Material kann jedoch auch ein Laminat als Träger umfassen, wobei das Laminat zumindest eines der zuvor genannten Materialien umfasst. Der Träger kann aber auch z. B. ein Laminat sein, welches aus zumindest zwei dieser Materialien besteht.

Bei dem Träger kann es sich um Polymervliese unter Verwendung von Kunststofffasern aus Polyethylen (PE), Polypropylen (PP), Polyacrylat, Polyamid (PA; PA-Vlies, Freudenberg), Polyacrylnitril, Polyester (PET) oder Polycarbonat (PC) handeln, wobei auch Mischungen verwendet werden können. Die Membrane können Polymervliese aufweisen, die flexibel sind und bevorzugt eine Dicke von weniger als 100 µm sowie ein Flächengewicht von kleiner als 50 g/m2 aufweisen. Bevorzugt ist der Träger deshalb ein Vlies, das eine Dicke von kleiner 30 µm, insbesondere von 10 bis 20 µm besitzt. Besonders bevorzugt ist der Träger ein Vlies, mit einem Flächengewicht von kleiner 20 g/m², insbesondere von 5 bis 15 g/m².

Um eine ausreichend hohe Leistungsfähigkeit der Batterien, insbesondere bei Lithiumionenbatterien, erreichen zu können, hat es sich als vorteilhaft erwiesen, wenn der Träger eine Porosität vorzugsweise von größer 50 %, bevorzugt von 50 bis 97 %, besonders bevorzugt von 60 bis 90 % und ganz besonders bevorzugt von 70 bis 90 % aufweist. Die Porosität P ist dabei definiert als das Volumen des Vlieses (V_{Vlies}) minus dem Volumen der Fasern des Vlieses (V_{Fasern}), wobei V_{Vlies} minus V_{Fasern} = V_{Hohlraum} ist, geteilt durch das Gesamtvolumen V_{Vlies}. Es gilt also P= (V_{Vlies}-V_{Fasern}) /V_{Vlies}. Das Volumen des Vlieses kann dabei aus den Abmessungen des Vlieses berechnet werden. Das Volumen der Fasern ergibt sich aus dem gemessen Gewicht des betrachteten Vlieses und der Dichte der Polymerfasern. Wichtig für die Verwendung als Träger kann eine möglichst homogene Porenradienverteilung im Vlies sein. Eine möglichst homogene Porenradienverteilung im Vlies kann in Verbindung mit optimal abgestimmten Oxid-Partikeln bestimmter Größe zu einer optimierten Porosität der erfindungsgemäßen Membran, insbesondere mit Blick auf den Einsatz als Separator führen. Vorzugsweise weist die erfindungsgemäße Membran, insbesondere für als Separator einzusetzende Membrane, deshalb ein Vlies auf, welches eine Porenradienverteilung aufweist, bei der mindestens 50 % der Poren einen Porenradius von 100 bis 500 µm aufweisen.

Als Polymerfasern weist das Vlies vorzugsweise elektrisch nicht leitfähige Fasern von Polymeren auf, die vorzugsweise ausgewählt sind aus Polyacrylnitril (PAN), Polyester, wie z. B. Polyethylenterephthalat (PET), Polyamid (PA), wie z. B. Polyamid 12 oder Polyolefinen, wie z. B. Polypropylen (PP) oder Polyethylen (PE). Besonders bevorzugt weist das Vlies Polymerfasern aus Polyester, insbesondere PET, und/oder Polyamid, insbesondere Polyamid 12, auf bzw. besteht vollständig aus diesen Polymerfasern. Die Polymerfasern der Vliese weisen vorzugsweise einen Durchmesser von 0,1 bis 10 µm, besonders bevorzugt von 1 bis 5 µm auf.

Die zu verarbeitenden Membranen/Separatoren weisen vorzugsweise eine Dicke von kleiner 100 µm, bevorzugt kleiner 50 µm, besonders bevorzugt eine Dicke von 5 bis 35 µm auf. Die Dicke des Separators hat einen großen Einfluss auf die Eigenschaften des Separators, da zum einen die Flexibilität aber auch der Flächenwiderstand des mit Elektrolyt getränkten Separators von der Dicke des Separators abhängig ist. Durch die geringe Dicke wird ein besonders geringer elektrischer Widerstand des Separators in der Anwendung mit einem Elektrolyten erzielt. Der Separator selbst weist natürlich einen sehr hohen elektrischen Widerstand auf, da er selbst isolierende Eigenschaften aufweisen muss. Zudem erlauben dünnere Separatoren eine erhöhte Packungsdichte in einem Batteriestapel, so dass man im gleichen Volumen eine größere Energiemenge speichern kann. Um beim Schneiden bzw. Stanzen so dünnen partikelhaltigen Materials zu im mikroskopischen Bereich sauberen Schnitten zu gelangen, eignen sich herkömmliche Schneid- oder Stanzwerkzeuge nicht. Erst die Schneid- und/oder Stanzwerkzeuge des erfindungsgemäßen Verfahrens ermöglichen solche reproduzierbaren sauberen Schnitte verbunden mit einer hohen Standzeit des Klingenmaterials.

Als Träger können aber auch poröse Kunststoff-Folien verwendet werden. Auf die von einer oder beiden Seiten eine keramische Schicht aufgebracht wird, so dass ein ähnlicher Verbundwerkstoff mit den oben beschriebenen Eigenschaften erhalten wird. Analog zu einem Kunststoffvlies lassen sich auch Kunststoffgewebe verarbeiten. In den Schriften WO 02/15299 und WO 02/071509 wird eine Methode zur Herstellung von Separatoren auf Basis von Polymer-Keramik-Kompositen beschrieben. Dabei wird ebenfalls eine Suspension eines anorganischen Materials aus eine polymeres Material aufgebracht.

Alternativ können - bspw. zur Einhaltung höherer Sicherheitsstandards in Batterien - flexible keramische Separatoren verwendet werden. Solche Separatoren werden z. B. in DE 102 08 277, DE 103 47 569, DE 103 47 566 oder DE 103 47 567 beschrieben.

Darüber hinaus werden in DE 199 18 856 A1 Separatoren beschrieben, die aus einem hitzebeständigen aromatischen Polymer sowie einem Keramikpulver bestehen, welche in einem Beschichtungsverfahren auf ein Substrat, bestehend aus einem Gewebe, Vlies Papier oder einer porösen Folie, aufgebracht werden. Diese Separatoren können ein thermoplastisches Harz enthalten, das bei unzulässig hoher Erwärmung der Zelle schmilzt und die Hohlräume des Trennelements schließt. Der Gehalt des Keramikpulvers beträgt hier bis zu 95 Gew.-% bezogen auf das Gesamtgewicht des Separators.

In einer bevorzugten Ausführungsform des erfindungsgemäßen Verfahrens besteht der Träger aus Kunststoff oder umfasst Kunststoff und ist zumindest ein Teil der abrasiven Partikel in der durch den Kunststoff gebildeten Matrix eingeschlossen. Alternativ kann der Träger aus porösem Kunststoff bestehen oder porösen Kunststoff umfassen, wobei sich zumindest ein Teil der abrasiven Partikel zumindest teilweise in den Poren des Kunststoffes befindet. Die abrasiven Partikel können sich auch zusätzlich oder ausschließlich auf zumindest einem Teil der Oberfläche des Trägers befinden.

Zur Herstellung eines typischen SEPARION-Vertreters wird vorzugsweise eine Dispersion eingesetzt, die einen Anteil an keramischen Partikeln an der gesamten Dispersion von 10 bis 60 Massen-%, bevorzugt von 15 bis 40 und besonders bevorzugt von 20 bis 30 Massen-% aufweist. In Bezug auf den Binder wird vorzugsweise eine Dispersion eingesetzt, die einen Anteil an organischen Binder von 0,5 bis 20 Massen-%, bevorzugt von 1 bis 10 Massen-% und besonders bevorzugt von 1 bis 5 Massen-% aufweist. Das Endprodukt hat für gewöhnlich einen Keramikanteil von 20 bis 90 Massen-% und ist lösungsmittel- und wasserfrei.

Unter "abrasive Partikel" im Sinne der vorliegenden Erfindung wird Material verstanden, das eine größere Härte aufweist als das komplementäre Material. Die Abrasivität lässt sich anhand der Mohshärte vorhersagen. Solche abrasiven Partikel können z. B. oxidische oder keramische Partikel mit einer Härte bis zu 9 Mohs besitzen. Dies entspricht Korund, also Aluminiumoxid. In einer bevorzugten Ausführungsform der Erfindung sind die abrasiven Partikel also oxidische oder keramische Partikel und weisen eine Mohssche Härte von mindestens 7, vorzugsweise mindestens 8, besonders bevorzugt mindestens 9 auf.

In der Mineralogie wird die Ritzhärte nach Mohs (Mohs-Härte) zur qualitativen Einordnung und zur Bestimmung der Mineralien verwendet. Man versteht darunter den Widerstand, den ein Mineral dem Eindringen eines Messers oder eines anderen Minerals entgegensetzt, das mit kräftigem Druck über eine frische, unverwitterte Bruch-, Spalt- oder Kristallfläche (vgl. Spaltbarkeit) geführt wird. So liegt die Mohs-Härte eines Minerals B zwischen jener des Minerals A, von dem es geritzt wird, und jener des Minerals C, das es selbst ritzt. Für den Wert der Mohs-Härte gilt dann M_{hA} > M_{hB} > M_{hC}. Die Mohs-Härte stellt einen dimensionslosen relativen Vergleichswert ohne physikalischen Hintergrund zwischen den *Mohsschen Härtegraden* 1 (Talk) und 10 (Diamant) dar.

| **Härtestufe** | **Referenzmineral** |
|---|---|
| 1 | Talk |
| 2 | Gips, Steinsalz (Fingernagel) |
| 3 | Calcit (Kupfer) |
| 4 | Fluorit (Reineisen) |
| 5 | Apatit (Cobalt) |
| 6 | Orthoklas(Silicium, Tantal) |
| 7 | Quarz (Wolfram) |
| 8 | Topas (Chrom, gehärteter Stahl) |
| 9 | Korund, Saphir |
| 10 | Diamant |

Der Tabelle ist zu entnehmen, dass Metalle eine geringere Härte besitzen (≤7), also von dem Separatormaterial geritzt werden können. Dadurch erklären sich der Abrieb des Messers und die reduzierte Standzeit der Klingen. Es ist also erforderlich, dass die Härte der Klingen größer oder mindestens gleich ist.

Als oxidische und/oder keramische Partikel seien beispielhaft genannt: Aluminiumoxid (Al₂O₃), Zirkoniumoxid (ZrO₂), Rutil (TiO₂), Quarz (SiO₂), Bariumtitanat (BaTiO₃), Magnesiumoxid (MgO), Indium-Zinn-Oxid (ITO) oder auch Mischungen dieser Werkstoffe, bzw. Mischungen, die diese Werkstoffe enthalten. Andere nicht-oxidische oder nicht-keramische abrasive Partikel (bspw. Putzkörper) können sein: Si₃N₄, Calciumcarbonat (CaCO₃), Aluminiumhydroxid (Al(OH)₃), Apatite (Ca₅(PO₄)₃X), Metalle (W).

In einer besonders bevorzugten Ausführungsform des erfindungsgemäßen Verfahrens handelt es sich bei dem zu schneidenden bzw. zu stanzenden Material um keramisches Separatorenmaterial, welches bevorzugt für den Einsatz in elektrochemischen Anwendungen, bspw. (Super-)Kondensatoren, Batterien, Lithium-Ionen-Batterien oder Lithium-Metall-Batterien, vorgesehen ist.

Unter "keramische Separatoren" im Sinne der vorliegenden Erfindung werden übliche in elektrochemischen Anwendungen eingesetzte Separatoren verstanden, die mit wie oben definierten "abrasiven Partikeln" beschichtet sind oder solche Partikel enthalten. Beispiele für solche elektrochemischen Anwendungen sind Kondensatoren, Superkondensatoren, Batterien, Lithium-lonen-Batterien und Lithium-Metall-Batterien.

In einer Ausführungsform des erfindungsgemäßen Verfahrens kann das zum Schneiden und/oder Stanzen verwendete Schneid- oder Stanzwerkzeug ein mit einem keramischen Werkstoff beschichtetes Schneid- oder Stanzwerkzeug sein. In diesem Fall kann die Oberfläche oder ein Teil der Oberfläche des Schneid- oder Stanzwerkzeugs mit einer oder mehreren Schichten, die aus Titancarbid (TiC), Titannitrid (TiN), Titancarbonitrid (TiCN), Zirkoncarbid (ZrC), Zirkonnitrid (ZrN), Zirkoncarbonitrid (ZrCN), Titanaluminiumnitrid (TiAIN), Aluminiumoxid (Al₂O₃), Zirkonoxid (ZrO₂), Titanoxid (TiO₂), Chromnitrid (CrN), Siliziumcarbid (SiC), Wolframcarbid (WC), Titanborid (TiB₂) oder polykristallinem kubischem Bornitrid (cBN), bestehen oder überwiegend diese Materialien enthalten, beschichtet sein. Die Beschichtung(en) können auch aus metallhaltigem (Metall = Ti, Cr, WC, u. ä.) amorphen Kohlenstoff bestehen oder überwiegend diese Materialien enthalten. Im Falle mehrerer übereinander liegender Schichten können die Schichten jeweils oder zum Teil aus einem anderem der oben genannten Materialien bestehen.

In den obigen Fällen, in denen die Schicht oder die Schichten aus TiC, TiN, TiCN, ZrC, ZrN, ZrCN, TiAlN, Al₂O₃, ZrO₂, TiO₂, metallhaltigem Molybdändisulfid oder metallhaltigem amorphen Kohlenstoff bestehen oder diese Materialien enthalten kann die jeweilige Schicht durch ein CVD-, PVD- oder PACVD-Verfahren aufgetragen werden.

Bei den PVD-Verfahren wird durch Aufdampfen (Bedampfen) das Beschichtungsmaterial, also z. B. Metalle wie Titan, Zirconium oder Aluminium, Oxide oder Salze wie etwa Siliciumdioxid, im Hochvakuum bis zum Übergang vom festen über den flüssigen in den gasförmigen Zustand erhitzt. Die notwendige Erwärmung geschieht durch Beschuss mit hochenergetischen Elektronen, durch Laser oder durch elektrische Widerstandsheizungen und je nach Schichtmaterial (bspw. TiAlN) auch einem Gas (N₂, Ar). Neben diesen Heiztechniken wird auch das Verfahren des Bogenverdampfens, bei dem durch Zünden eines Lichtbogens zwischen zwei Elektroden das Elektrodenmaterial verdampft wird, eingesetzt.

Im Gegensatz zu den PVD-Verfahren laufen bei CVD-Verfahren chemische Prozesse ab. Aus Edukten (precursor, Vorläufer) wird erst während des Prozesses die abzuscheidende Komponente erzeugt. Die Temperaturen liegen bei diesem Prozess zwischen 200 und 2000 °C. Je nach der Art der Energiezufuhr spricht man von thermisch-, Plasma-, Photonen- oder Laser-aktivierter Gasphasenabscheidung. Die einzelnen Gaskomponenten werden mit einem Trägergas bei Drücken zwischen 1 und 100 kPa durch eine Reaktionskammer geleitet, in der die chemische Reaktion stattfindet und sich die dabei gebildeten Festkörperkomponenten als dünne Schicht abscheiden. Z. B. 2 TiCl4 + 2 NH3 + H2 → 2 TiN + 8 HCl. Die flüchtigen Nebenprodukte werden mit dem Trägergas abgeführt. Mit der chemischen Gasphasenabscheidung lassen sich Substrate (vorausgesetzt, sie sind bei den Temperaturen stabil) mit zahlreichen Metallen, Halbleitern, Karbiden, Nitriden, Boriden, Siliciden und Oxiden beschichten. Die Anwendung liegt unter anderem in der Herstellung von Verschleißschutzschichten aus z. B. Titannitrid, Titancarbid, Diwolframcarbid oder Korrosionsschutz-Schichten z. B. aus Niobcarbid, Bornitrid, Titanborid, Aluminiumoxid, Tantal und Silicide. Die Schichten erreichen gewöhnlich Stärken von 0,1 bis 1 µm.

Kristalline Diamantschichten können aus einem Prozessgas mit 1 % Methan und 99 % Wasserstoff unter Vakuum und bei hohen Temperaturen abgeschieden werden. Die Schichten erreichen ebenfalls Stärken von 0,1 bis 1 µm.

### Wichtige Beispiele dieser Schichten sind:

### Titanaluminiumnitrid (TiAIN):

Härte: ca. 3.300 HV
Oxidation ab: bis 800 °C
Schichtstärke: bis zu einigen µm
Beschichtungstemperatur: ab 180 bis 450 °C
Durch Temperatureinwirkung bei der Anwendung bildet sich Aluminiumoxid auf der Oberfläche. Das führt zu einer hervorragenden Wärmeableitung und einer extrem hohen Härte des Materials.

### Titancarbonitrid (TiCN):

Härte: ca. 3.000 HV
Oxidation ab: 400 °C
Schichtstärke: bis zu einigen µm
Beschichtungstemperatur:
ab 300 bis 450 °C
Dieses Material bietet eine sehr hohe Härte.

| **Mineral** | **Härte (Mohs)** | **Vickershärte in HV** | **Bemerkungen** |
|---|---|---|---|
| Talk | 1 | 2,4 | mit Fingernagel schabbar |
| Gips oder Halit | 2 | 36 | mit Fingernagel ritzbar |
| Calcit | 3 | 109 | mit Kupfermünze ritzbar |
| Fluorit | 4 | 189 | mit Messer leicht ritzbar |
| Apatit oder Mangan | 5 | 536 | mit Messer noch ritzbar |
| Orthoklas | 6 | 795 | mit Stahlfeile ritzbar |
| Quarz | 7 | 1.120 | ritzt Fensterglas |
| Topas | 8 | 1.427 | |
| Korund | 9 | 2.060 | |
| Diamant | 10 | 10.060 | härtestes natürlich vorkommendes Mineral |

In den Fällen, in denen die Schicht oder die Schichten aus TiC, TiN, TiCN, ZrC, ZrN, ZrCN, TiAlN, Al₂O₃, ZrO₂, TiO₂, metallhaltigem Molybdändisulfid oder metallhaltigem amorphen Kohlenstoff bestehen oder diese Materialien enthalten kann die jeweilige Schicht durch ein Flammspritzverfahren aufgetragen werden.

In einem sog. Flammspritzverfahren, dies ist ein Fertigungsverfahren zur Oberflächenveredelung von (metallischen) Werkstücken, wird die metallische Oberfläche der Klinge bei hohen Temperaturen mit einem Material belegt, das eine hohe Härte besitzt. Dies können die oben erwähnten Oxide sein. Dafür wird der pulver- oder drahtförmige Spritzzusatz in einer Brenngas-Sauerstoff (oder auch andere Gase beinhaltend)-Flamme geschmolzen und durch das Verbrennungsgas allein oder mit Unterstützung durch ein Zerstäubergas auf die geeignet vorbereitete Werkstückoberfläche gespritzt. Die geschmolzenen Spritzpartikel erstarren, haften auf der Werkstückoberfläche und bilden dort eine mehr oder weniger geschlossene Beschichtung. Neben keramischen Werkstoffen können auf diese Weise auch metallische Beschichtungen hergestellt werden. Literatur: DIN 8522: 1980-09, Fertigungsverfahren der Autogentechnik, Übersicht.; DIN EN 657: 2005-06, Thermisches Spritzen - Begriffe, Einteilung; Römpp Chemie Lexikon Online, Thieme Verlag.

Dieses Verfahren erlaubt die Beschichtung unterschiedlichster ggf. individuell vorbereiteter Oberflächen aber insbesondere jeglicher Geometrien. Dadurch ist es möglich sämtliche Klingen-, Messer- oder Schneidformen erfolgreich zu beschichten. Die erhaltenen Schichtdicken der fertigen Werkzeuge belaufen sich - im Gegensatz zu den weiter oben beschriebenen in PVD-/CVD-Verfahren erhaltenen Schichten - im zweistelligen µm-Bereich bis hin zu einigen Millimetern. Mit diesem Verfahren wird also die Auswahl an erhältlichen Schichtdicken erweitert und so auch die Anwendbarkeit der erhaltenen Arbeitsmaterialien (Klingen und Schneiden bzw. Stanzen) erweitert. So kann mit diesen dickeren Schichten beispielsweise eine weichere Schicht aufgebracht werden, die einerseits einen geringeren Reibungswiderstand besitzt und anderseits zwar einen geringen Abrieb auf dem härteren zu schneidenden bzw. zu stanzenden Werkstoff besitzt, der jedoch auf Grund seiner keramischen Beschaffenheit unbedenklich ist. Auf Grund der Schichtdicke ist die Standzeit des Werkzeugs dann auch noch ausreichend hoch.

Im Flammspritzverfahren erhaltene Beschichtungen sind für die erfindungsgemäße Anwendung in einem zusätzlichen Arbeitsschritt nachzuarbeiten, d. h. zu schleifen und polieren, um Oberflächenunebenheiten zu eliminieren.

Eine weitere Möglichkeit besteht darin, dass die Beschichtung(en) aus Diamant oder diamantartigem Material insbesondere Kohlenstoff (C) und kubisches Bornitrid (BN) bestehen.

Die Herstellung einer nanokristallinen Diamantbeschichtung erfolgt in der Regel mit einer chemischen Gasphasenabscheidung (Chemical Vapour Deposition - CVD). Im sog. Hot-Filament CVD (HFCVD) Verfahren - ein Vertreter der thermischen CVD Verfahren - wird die Diamantbeschichtung aufgebracht. Dies ist ein übliches Verfahren zur oberflächlichen Veredelung von Werkstoffe. So werden nana- und/oder mikrokristalline Diamantschichten erhalten. Die erhaltenen Schichten sind aufwendig herzustellen (ggf. schlechte Haftung auf dem Substrat) und dadurch sehr kostenintensiv, bieten jedoch den besten Verschleißschutz bei einem gleichzeitig äußerst geringen Reibwert. Außerdem lassen sich Diamantschichten auf die Substrate mittels PVD oder Pulsed Laser Deposition (PLD) aufbringen.

Dabei besteht in den oben genannten Fällen das beschichtete Schneidwerkzeug selbst vorzugsweise aus Stahl, z. B. aus 1.4034 Messerstahl.

Die als Substrate zu verwendenden Stähle sollten eine möglichst hohe Anlasstemperatur besitzen. Dies ist die Temperatur, bei der Versprödungserscheinungen aus einem vorausgehenden Härtungsschritt oder einer anderen Wärmebehandlung ganz oder teilweise rückgängig gemacht werden. Dieses Rückgängigmachen ist bei hartem Messerstahl und auch für eine PVD oder CVD Nachbehandlung unerwünscht, so dass folglich mit den Stählen unterhalb dieser Temperatur gearbeitet werden muss. Je höher also die Anlasstemperatur eines Stahls liegt, desto höheren Temperaturen darf dieser Stahl bei der Verwendung ausgesetzt werden ohne dass er seine gehärtete Struktur verliert.

Typischerweise verwendete Stähle sind: Deutscher Messerstahl ist X46Cr13 (Werkstoffnummer 1.4034, amerikanische Bezeichnung AISI 420 C). Er ist laut Werkstoffbezeichnung hochlegiert und enthält 0,46 % Kohlenstoff und 13 % Chrom. Chrom sorgt als Ferritbildner einerseits für die Elastizität und die Härte und wirkt andererseits gegen Oxidation (Rostfreiheit).

Ein speziell für Messerklingen entwickelter Stahl ist der pulvermetallurgische Stahl CPM S30V von Crucible Materials Corp., Syracuse USA. Dieser Stahl enthält 1,45 % Kohlenstoff, 14 % Chrom, 4 % Vanadium und 2 % Molybdän. Weiterhin können nichtrostende Stähle verwendet werden:

| **EN-Norm** Werkstoff-Nr. | **EN-Norm Kurzname** |
|---|---|
| 1.4016 | X6Cr17 |
| 1.4509 | X2CrTiNb18 |
| 1.4510 | X3CrTi17 |
| 1.4512 | X2CrTi12 (alt X6 CrTi 12) |
| 1.4526 | X6CrMoNb17-1 |
| 1.4310 | X10CrNi18-8 (alt X12 CrNi17 7) |
| 1.4318 | X2CrNiN18-7 |
| 1.4307 | X2CrNi18-9 |
| 1.4306 | X2CrNi19-11 |
| 1.4311 | X2CrNiN18-10 |
| 1.4301 | X5CrNi18-10 |
| 1.4948 | X6CrNi18-11 |
| 1.4303 | X4CrNi18-12 (alt X5 CrNi18 12) |
| 1.4541 | X6CrNiTi18-10 |
| 1.4878 | X10CrNiTi18-10 (alt X12 CrNiTi18 9) |
| 1.4404 | X2CrNiMo17-12-2 |
| 1.4401 | X5CrNiMo17-12-2 |
| 1.4406 | X2CrNiMoN17-11-2 |
| 1.4432 | X2CrNiMo17-12-3 |
| 1.4435 | X2CrNiMo18-14-3 |
| 1.4436 | X3CrNiMo17-13-3 |
| 1.4571 | X6CrNiMoTi17-12-2 |
| 1.4429 | X2CrNiMoN17-13-3 |
| 1.4438 | X2CrNiMo18-15-4 |
| 1.4539 | X1NiCrMoCu25-20-5 |
| 1.4547 | X1CrNiMoCuN20-18-7 |

In einer anderen Ausführungsform des erfindungsgemäßen Verfahrens kann das zum Schneiden und/oder Stanzen verwendete Schneid- bzw. Stanzwerkzeug zumindest überwiegend aus einem keramischen Werkstoff (C, Abkürzungen nach ISO 513) oder aus polykristallinem kubischen Bornitrid (BN) bestehen. Die aus einem keramischen Werkstoff bestehenden Schneid- bzw. Stanzwerkzeuge werden auch Schneidkeramiken genannt. Hierfür werden die keramischen Rohlinge in die gewünschte Form geschliffen. Die so erhaltenen Keramikklingen können dann wie die stahlbasierten Originale verwendet werden. Das polykristalline kubische Bornitrid kann als Schicht durch das sogenannte Hochdruck-Flüssigphasensintern auf Hartmetallplatten aufgebracht oder als massiver Körper hergestellt werden, wobei als Bindephase Titannitrid oder Titancarbid dienen kann.

Die erfindungsgemäß einsetzbaren Schneidkeramiken können oxidische Keramiken (CA), Nichtoxidkeramiken (CN), Mischkeramiken (CM) und whiskerverstärkte Keramiken (CR) sein. Oxidische Keramiken können z. B. aus Aluminiumoxid (Al₂O₃), Zirkonoxid (ZrO₂) oder Titanoxid (TiO₂) bestehen. Besonders geeignet sind auch oxidische Mischkeramiken, z. B. solche auf Basis von Aluminiumoxid, die bis zu 20 % dispergiertes Zirkonoxid (ZrO₂) enthalten. Von den Nichtoxidkeramiken eignet sich insbesondere eine Keramik aus Siliciumnitrid (Si₃N₄). Die ebenfalls geeigneten Mischkeramiken werden z. B. aus Aluminiumoxid und Hartstoffen wie Titancarbid, Wolframcarbid oder Titannitrid gesintert. Whiskerverstärkte Schneidkeramiken sind mit Siliciumwhiskern verstärkte keramische Verbundwerkstoffe auf Basis von Aluminiumoxid.

**Figur 1** zeigt einen etwa 50 µm dicken keramischen Separator, der mit einem herkömmlichen edelstahlbasierten Messer geschnitten wurde. Das edelstahlbasierte Messer führt zu einem deutlich erkennbaren Metallabrieb. Die Skala in Figur 1 entspricht der in Figur 2 wiedergegebenen Skala.

**Figur 2** zeigt einen etwa 50 µm dicken keramischen Separator, der erfindungsgemäß mit einer Schere mit Keramikklingen geschnitten wurde. Ein Metallabrieb ist praktisch nicht zu erkennen. Analoge Ergebnisse werden mit einem Stapelschneider mit keramischen Klingen oder keramisch beschichteten Messern erhalten.

### Beispiele

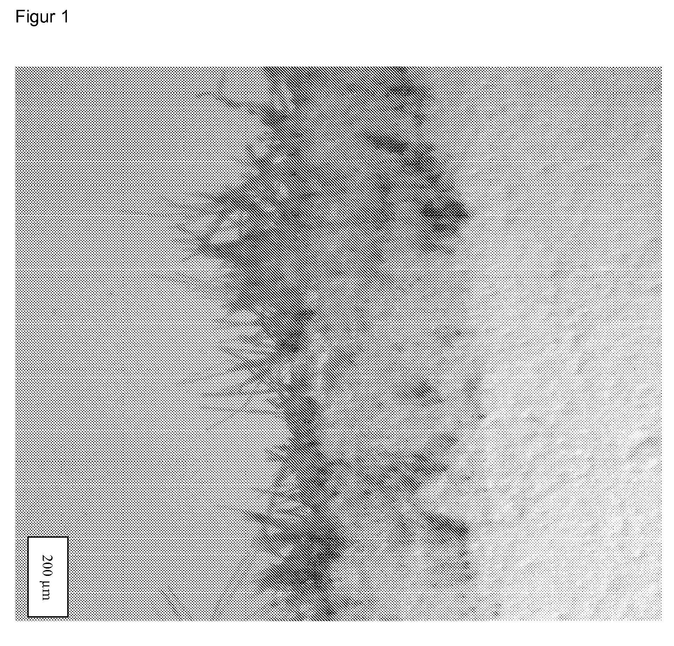

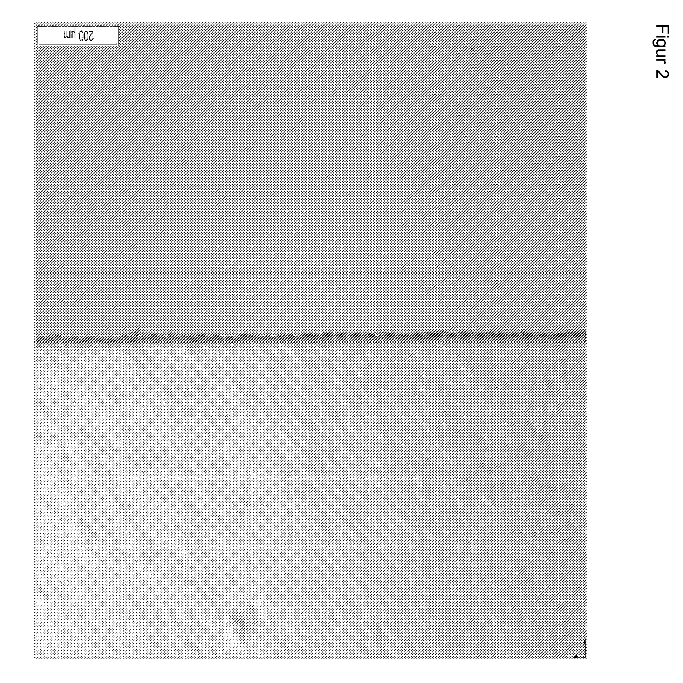

Die Figuren 1 und 2 zeigen beispielhaft die Schnittergebnisse mit Standardschneiden (Stahl, unbehandelt; Figur 1) und optimierten Schneiden (gehärtet bzw. mit Keramik belegt; Figur 2).

### Beispiel 1

Zum Schneiden kleiner Mengen (einzelne Blätter) keramikhaltiger Membranen wurden die Schneiden einer Hebelschere von Dahle (Typ 00561) Hebel-Schneidemaschine mit stabilem Metalltisch; Geschraubtes Obermesser mit Flachschliff und geschliffenes Untermesser aus Solinger Messerstahl) mit einer harten Oberfläche ausgerüstet. Nach Demontage und Reinigung der Ober- und Untermesser wurde in einem PVD-Verfahren die Oberfläche mit Titanaluminiumnitrid (TiAlN) versehen. Dicke ca. 5 µm.

Beim Schnitt von ca. 50 µm dicken SEPARION® Folien konnte ein sehr sauberes Schnittbild ohne Metallabrieb (vergleichbar mit dem in Figur 1) erhalten werden. Durch die Beschichtung ließ sich die Standzeit (Def: Dauer bis zum nächsten notwendigen Schliff, wenn sich die Schnittqualität auf Grund von Ausrissen oder Riefen im Schnittgut wesentlich verschlechtert hat) um mehr als den Faktor fünf verbessern. Ein Nachschleifen war vorher nicht notwendig.

### Beispiel 2

Zum Schneiden gestapelter Lagen von SEPARION® (ca. 100 Stück bei ca. 50 µm Dicke in Breiten bis zu 250 mm) wurde eine Stapelscheidmaschine der Firma IDEAL (Modell 6550) verwendet. Die mitgelieferten Messer wurden ebenfalls einer Reinigung unterzogen und anschl. mit TiCN in einem PVD-Verfahren in einer Dicke von 1 µm beschichtet. Werden mit diesem Setup die oben genannten Stapel von SEPARION® geschnitten, lassen sich bei keinem Schnitt Verfärbungen der Schnittkanten feststellen. Dies ließ sich auch anhand von REM-EDX-Analysen bestätigen, in denen keine Verunreinigungen identifiziert werden konnten.

### Beispiel 3

Eine keramische Folie SEPARION® wird mit einer Schere aus Keramik des Herstellers Kyocera auf die gewünschte Größe zurechtgeschnitten. Mit diesem Werkzeug lässt sich der Werkstoff sauber und rückstandsfrei schneiden. Man findet ein sauberes Schnittbild ohne Metallabrieb vergleichbar mit dem in Figur 1 gezeigten.

### Beispiel 4

Mittels eines kreisrunden Locheisens mit dem Durchmesser 4 cm wurden kreisrunde Stücke der keramischen Folie ausgestanzt. Mit diesem Werkzeug lässt sich der Werkstoff sauber und rückstandsfrei schneiden. Man findet eine saubere Kante ohne Metallabrieb vergleichbar mit dem in Figur 1 gezeigten.

### Vergleichsbeispiel 1 (zu Beispiel 2)

Zum Schneiden gestapelter Lagen von SEPARION® (ca. 100 Stück bei ca. 50 µm Dicke in Breiten bis zu 250 mm) wurde eine Stapelscheidmaschine der Firma IDEAL (Modell 6550) verwendet. Werden solche Stapel SEPARION® mit den mitgelieferten Klingen geschnitten, stellt man an der Schnittkante bereits beim ersten Schnitt erheblichen Abrieb der Klinge fest. Dies äußert sich durch eine Verschmutzung der Schnittkante (graue Verfärbung).

### Vergleichsbeispiel 2 (zu Beispiel 3)

Als einfacher Versuch zur Verdeutlichung der Abrasivität der keramischen Folie SEPARION® wird diese mit einer handelsüblichen Büroschere (gehärteter Klingenstahl) in einzelnen Lagen geschnitten. Die Schnittkanten sind unsauber, ausgefranst, und es zeigt sich an und auf der Schnittkante Abrieb in Form grauschwarzer Partikel vergleichbar mit der in Figur 1 gezeigten Schnittkante.

## Patentansprüche

1. Verfahren zum Schneiden und/oder Stanzen eines Materials, das einen Träger und abrasive Partikel umfasst, wobei sich die abrasiven Partikel innerhalb und/oder auf zumindest einem Teil der Oberfläche des Trägers befinden, **dadurch gekennzeichnet, dass** zum Schneiden und/oder Stanzen des Materials ein mit einem keramischen Werkstoff beschichtetes Schneid- oder Stanzwerkzeug oder ein aus einem keramischen Werkstoff bestehendes Schneid- oder Stanzwerkzeug oder ein sonstiges einen keramischen Werkstoff umfassendes Schneid- oder Stanzwerkzeug verwendet wird.

2. Verfahren nach Anspruch 1, wobei der Träger aus Kunststoff, aus porösem Kunststoff, aus einem Vlies oder Gewebe aus solchen Kunststoffen, aus Papier oder Pappe besteht oder zumindest eines dieser Materialien umfasst oder wobei der Träger ein Laminat umfassend zumindest eines dieser Materialien oder ein Laminat bestehend aus zumindest zwei dieser Materialien ist.

3. Verfahren nach einem der vorhergehenden Ansprüche, wobei der Träger aus Kunststoff besteht oder Kunststoff umfasst und zumindest ein Teil der abrasiven Partikel in der durch den Kunststoff gebildeten Matrix eingeschlossen ist oder wobei der Träger aus porösem Kunststoff besteht oder porösen Kunststoff umfasst und sich zumindest ein Teil der abrasiven Partikel zumindest teilweise in den Poren des Kunststoffes befindet.

4. Verfahren nach einem der vorhergehenden Ansprüche, wobei die abrasiven Partikel oxidische oder keramische Partikel sind und eine Mohssche Härte von mindestens 7, vorzugsweise mindestens 8, besonders bevorzugt mindestens 9 aufweisen.

5. Verfahren nach einem der vorhergehenden Ansprüche, wobei das zu schneidende und/oder stanzende Material keramisches Separatorenmaterial, bevorzugt für den Einsatz in elektrochemischen Anwendungen, besonders bevorzugt in Kondensatoren, Superkondensatoren, Batterien, Lithium-lonen-Batterien oder Lithium-Metall-Batterien, ist.

6. Verfahren nach einem der Ansprüche 1 bis 5, wobei das zum Schneiden und/oder Stanzen verwendete Schneid- oder Stanzwerkzeug mit einer oder mehreren Schichten, die jeweils unabhängig voneinander aus TiC, TiN, TiCN, ZrC, ZrN, ZrCN, TiAlN, Al₂O₃, ZrO₂, TiO₂, CrN, SiC, WC, TiB₂, cBN oder metallhaltigem amorphen Kohlenstoff bestehen oder überwiegend diese Materialien enthalten, beschichtet ist.

7. Verfahren nach Anspruch 6, wobei die aus TiC, TiN, TiCN, ZrC, ZrN, ZrCN, TiAlN, Al₂O₃, ZrO₂, TiO₂, CrN, SiC, WC, TiB₂, cBN oder metallhaltigem amorphen Kohlenstoff bestehende(n) oder diese Materialien enthaltende(n) Schicht(en) durch ein CVD-, PVD- oder PACVD-Verfahren aufgetragen wurde(n).

8. Verfahren nach Anspruch 6, wobei die aus TiC, TiN, TiCN, ZrC, ZrN, ZrCN, TiAlN, Al₂O₃, ZrO₂, TiO₂, CrN, SiC, WC, TiB₂, cBN oder metallhaltigem amorphen Kohlenstoff bestehende(n) oder diese Materialien enthaltende(n) Schicht(en) durch ein Flammspritzverfahren aufgetragen wurde(n).

9. Verfahren nach einem der Ansprüche 1 bis 5, wobei das zum Schneiden und/oder Stanzen verwendete Schneid- oder Stanzwerkzeug mit einer oder mehreren Schichten, die aus Diamant oder einem diamantartigen Material bestehen, beschichtet ist.

10. Verfahren nach einem der Ansprüche 1 bis 5, wobei das zum Schneiden und/oder Stanzen verwendete Schneid- oder Stanzwerkzeug aus polykristallinem kubischen Bornitrid (BN) besteht oder eine Schneidkeramik (C), insbesondere eine oxidische Keramik (CA), Nichtoxidkeramik (CN), Mischkeramik (CM) oder whiskerverstärkte Keramik (CR), ist.

11. Verfahren nach einem der vorhergehenden Ansprüche, wobei das zu schneidende und/oder stanzende Material mit einem Schneid- oder Stanzwerkzeug geschnitten und/oder gestanzt wird, das ausgewählt wird aus der Liste, die Stanzen, Scheren, Messern, Cuttern, Hebelscheren, Stapelschneidern, Rollenschneidern, Längs- und Querschneideanlagen umfasst und wobei die Schneide(n) des verwendeten Schneid- oder Stanzwerkzeuges gegebenenfalls als gerade, gebogene oder runde Schneide oder Stanze ausgeführt ist/sind.

12. Verwendung des in einem der Ansprüchen 6 bis 11 definierten Schneid- oder Stanzwerkzeuges zum Schneiden und/oder Stanzen des in einem der Ansprüchen 1 bis 5 beschriebenen Materials.
